(19) Europäisches Patentamt / European Patent Office / Office européen des brevets

(11) **EP 4 482 036 B1**

(12) **EUROPEAN PATENT SPECIFICATION**

(45) Date of publication and mention of the grant of the patent:
**08.04.2026 Bulletin 2026/15**

(21) Application number: **23305983.1**

(22) Date of filing: **21.06.2023**

(51) International Patent Classification (IPC):
**H03M 1/12** (2006.01)   **G01R 21/133** (2006.01)
**H02M 3/157** (2006.01)   **G01R 19/25** (2006.01)

(52) Cooperative Patent Classification (CPC):
**H03M 1/1265; G01R 19/2509; G01R 21/133;**
**H03M 1/125**

(54) **DEVICE AND METHOD FOR CONTINUOUS-TIME ENERGY CALCULATION OF AN ANALOG SIGNAL**

VORRICHTUNG UND VERFAHREN ZUR ZEITKONTINUIERLICHEN ENERGIEBERECHNUNG EINES ANALOGEN SIGNALS

DISPOSITIF ET PROCÉDÉ DE CALCUL D'ÉNERGIE EN TEMPS CONTINU D'UN SIGNAL ANALOGIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**25.12.2024 Bulletin 2024/52**

(73) Proprietors:
- **Centre National de la Recherche Scientifique**
  **75016 Paris (FR)**
- **JUNIA**
  **59046 Lille Cedex (FR)**
- **Université de Lille**
  **59800 Lille (FR)**
- **Université Polytechnique Hauts-de-France**
  **59313 Valenciennes Cedex 9 (FR)**
- **STMicroelectronics Crolles 2 SAS**
  **38920 Crolles (FR)**

(72) Inventors:
- **FRAPPE, Antoine**
  **59110 LA MADELEINE (FR)**
- **LARRAS, Benoit**
  **59000 LILLE (FR)**
- **CATHELIN, Andreia**
  **38190 LAVAL-EN-BELLEDONE (FR)**
- **MOURRANE, Soufiane**
  **38100 GRENOBLE (FR)**

(74) Representative: **Hautier IP**
**20, rue de la Liberté**
**06000 Nice (FR)**

(56) References cited:
**US-A1- 2021 257 908**

- **MOURRANE SOUFIANE ET AL: "Event-Driven Continuous-Time Feature Extraction for Ultra Low-Power Audio Keyword Spotting", 2021 IEEE 3RD INTERNATIONAL CONFERENCE ON ARTIFICIAL INTELLIGENCE CIRCUITS AND SYSTEMS (AICAS), IEEE, 6 June 2021 (2021-06-06), pages 1 - 4, XP033929651, DOI: 10.1109/AICAS51828.2021.9458425**
- **WU TZU-FAN ET AL: "A Flash-Based Non-Uniform Sampling ADC With Hybrid Quantization Enabling Digital Anti-Aliasing Filter", IEEE JOURNAL OF SOLID-STATE CIRCUITS, IEEE, USA, vol. 52, no. 9, 27 July 2017 (2017-07-27), pages 2335 - 2349, XP011659292, ISSN: 0018-9200, [retrieved on 20170823], DOI: 10.1109/ JSSC.2017.2718671**
- **MOURRANE SOUFIANE ET AL: "Low-Power Event-Driven Spectrogram Extractor for Multiple Keyword Spotting: A proof of concept", 2023 21ST IEEE INTERREGIONAL NEWCAS CONFERENCE (NEWCAS), IEEE, 26 June 2023 (2023-06-26), pages 1 - 5, XP034392200, DOI: 10.1109/NEWCAS57931.2023.10198120**

**Description**

The present invention concerns a device for continuous-time energy calculation of an analog signal.

The invention also concerns an associated method for continuous-time energy calculation of an analog signal.

To calculate the energy from an analog signal, it is well known to perform discrete-time digital signal processing. In this case, a clock is used to sample the analog signal, and to synchronize subsequent processing operations. In this case, the power consumed for the discrete-time digital signal processing is constant in time, and depends on the frequency of the clock: the higher the frequency, the greater the power consumed.

This leads to high power consumption, which is wasteful in particular in settings where the analog signal is sparse. This is the case for example in voice signal processing, where a voice signal can alternate with long periods of silence or of non-significant noise. Voice signal processing is particularly relevant in keyword spotting applications, where the recognition of one keyword will result in an action being performed by a system, with applications in connected objects and real-time sensing.

Document MOURRANE SOUFIANE ET AL: "Event-Driven Continuous-Time Feature Extraction for Ultra Low-Power Audio Keyword Spotting", 2021 IEEE 3RD INTERNATIONAL CONFERENCE ON ARTIFICIAL INTELLIGENCE CIRCUITS AND SYSTEMS (AICAS), IEEE, 6 June 2021 (2021-06-06), pages 1-4, XP033929651 DOI: 10.1109/AICAS51828.2021.9458425, proposes a low power feature extraction unit generating spectrograms that represent a unique signature allowing the classification of audio signals.

US 2021/257908 A1 concerns instantaneous power estimation in a continuous time digital signal processing system.

Document WU TZU-FAN ET AL: "A Flash-Based Non-Uniform Sampling ADC With Hybrid Quantization Enabling Digital Anti-Aliasing Filter", IEEE JOURNAL OF SOLID-STATE CIRCUITS, IEEE, USA, vol. 52, no. 9, 1 September 2017 (2017-09-01), pages 2335-2349, XP011659292, ISSN: 0018-9200, DOI: 10.1109/JSSC.2017.2718671 concerns different classes of analog-to-digital converter (ADC) architecture that non-uniformly samples the analog input and shifts from conventional voltage quantization to a hybrid quantization paradigm wherein both voltage and time quantization are utilized.

To decrease power consumption, it is known to perform continuous-time digital signal processing, and in particular, continuous-time non-uniform amplitude sampling of the analog signal. However, this leads to the absence of a time reference, making it impossible to calculate an energy value from the analog signal.

The present invention aims to solve this problem, by calculating the energy of the analog signal while reducing the power consumption.

To this end, the invention consists in a device, for continuous-time energy calculation of an analog signal, comprising:

- a continuous-time analog-to-digital converter, configured to convert the analog signal into a request signal, the request signal comprising at least one pulse, each pulse being representative of the analog signal crossing one of a plurality of predetermined levels, and a direction signal, associated to the request signal, the direction signal being representative of a direction of the level crossing;
- at least one filtering unit, configured to perform a continuous-time finite impulse response filtering operation, the at least one filtering unit being configured to receive the request signal, the direction signal, and to output a filtered output signal, the at least one filtering unit comprising:

  o a delaying module, configured to receive the request signal and the direction signal, and to output at least one delayed request signal, delayed from the request signal by a delay time, and at least one delayed direction signal, delayed from the direction signal by the delay time, the at least one delayed request signal being associated with one of the at least one delayed direction signal; and
  o a calculating module, connected to the delaying module the calculating unit being configured to receive the request signal, the direction signal, the at least one delayed request signal and the at least one delayed direction signal and to calculate the filtered output signal.

According to the invention, the device further comprises:

- at least one pulse combiner, connected to the delaying module, the at least one pulse combiner being configured to receive the request signal and the at least one delayed request signal and to output a combined request signal; and
- at least one energy estimator, connected to the filtering unit and to the pulse combiner, the at least one energy estimator being configured to receive the filtered output signal and the combined request signal and configured to compute a stored energy value associated with each pulse of the combined request signal..

Advantageously, the combined request signal acts as a non-uniformly distributed time base, which is then used to track the variations in the filtered output. More specifically, it can be used as a time base to calculate the energy value associated with the filtered output. Thus, the energy present in the analog signal is calculated using continuous-time processing, which enables the decrease of the power consumption.

According to certain embodiments of the invention, the device comprises one or several of the following characteristics, separately, or according to any technically possible combinations:

- The combined request signal is a result of a concatenation of the request signal and the at least one delayed request signal.
- The delaying module comprises a plurality of successive delay blocks, each delay block applying said delay time, a delayed request signal and a delayed direction signal being obtained as an output of each delay block.
- The at least one calculating module comprises a plurality of multiply-accumulate blocks, each multiply-accumulate block receiving one of the plurality of delayed request signals and the delayed direction signal associated to the delayed request signal, or the request signal and direction signal.
- Each multiply-accumulate block is associated with a coefficient.
- The at least one pulse combiner is configured to receive all or only some of the plurality of delayed request and associated direction signals.
- The at least one energy estimator comprises:

  - a combinatory squarer configured to output a squared filtered output signal at each rising edge of the combined request signal;
  - an accumulator, configured to add the squared filtered output signal to a stored energy value to obtain an updated energy value and to set a value of the stored energy value to the updated energy value at each rising edge of the combined request signal, and the accumulator is further configured to receive a frame signal, comprising alternating high states and low states, and the frame signal goes from a high state to a low state, to output the stored energy value and then set the stored energy value to zero.
  - The device comprises a plurality of energy estimators, each energy estimator being configured to receive a different frame signal.
  - The delaying module and/or the at least one calculating module and/or the at least one pulse combiner and/or the at least one energy estimator is implemented on an integrated circuit comprising at least one fully depleted silicon on insulator transistor.

The invention also relates to a method for continuous-time energy calculation of an analog signal, the method being implemented by a device according of any of the preceding claims, the method comprising:

- converting the analog signal into the request signal, the request signal comprising at least one pulse, each pulse being representative of the analog signal crossing one of the plurality of predetermined levels, and into the direction signal, associated to the request signal, the direction signal being representative of the direction of the level crossing;
- filtering the request signal and the direction signal by a finite impulse response filtering operation
- the filtering comprising:

  o delaying the request signal and the associated direction signal to output the at least one delayed request signal, delayed from the request signal by the delay time, and the delayed direction signal associated to the at least one delayed request signal, delayed from the direction signal by the delay time;
  o calculating from the request signal, the direction signal, the at least one delayed request signal and the at least one delayed direction signal the filtered output signal;

- combining the request signal and the at least one delayed request signal into the combined request signal acting as a non-uniform time base; and

computing the stored energy value associated with each pulse of the combined request signal from the filtered output signal.

The features and advantages of the invention will appear upon reading the following description, given only as an example and not limited to the following description, and making reference to the enclosed drawings, wherein:

- [Fig. 1] figure 1 is a top view of an integrated circuit according to an embodiment of the invention;

- [Fig. 2] figure 2 is a schematic of the device of figure 1;

- [Fig. 3] figure 3 is a detailed schematic of the device;

- [Fig. 4] figure 4 is a schematic of detail IV of figure 3;

- [Fig. 5] is a graph showing states of the device during its operation as a function of time; and

- [Fig. 6] is a flowchart of a method according to an embodiment of the invention.

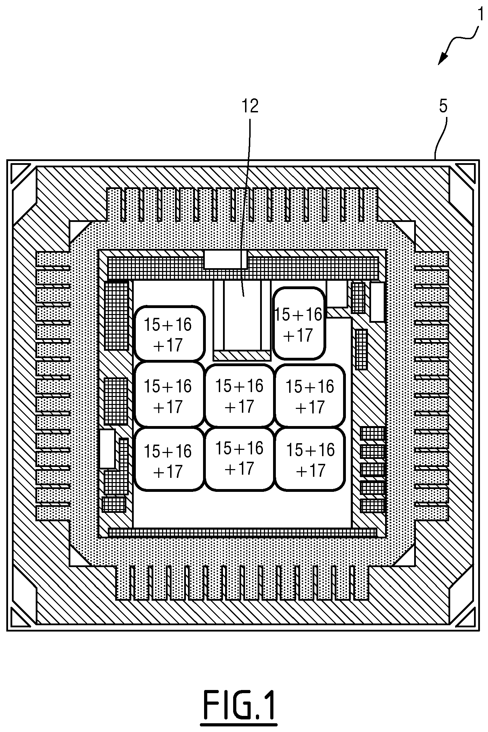

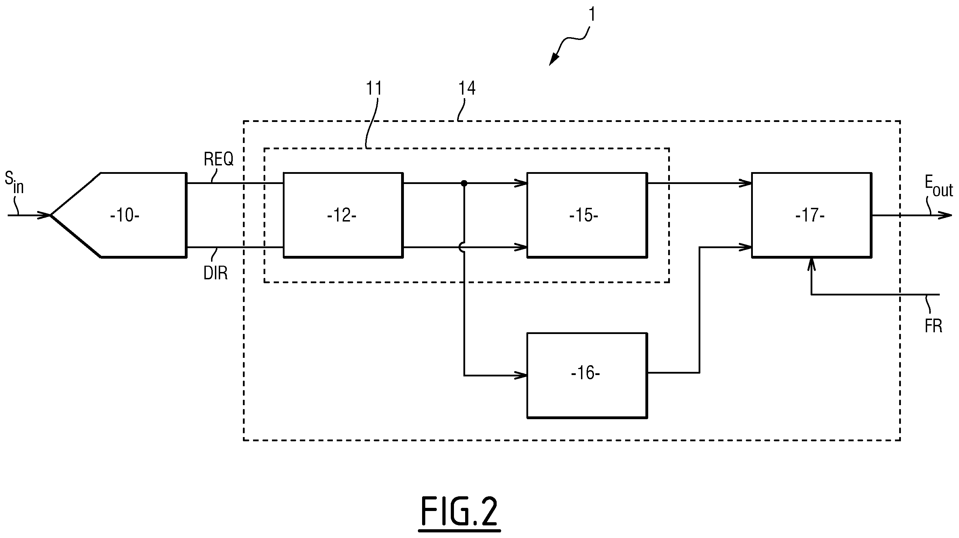

Figure 1 is a view of an integrated device 1 according to an embodiment of the invention. The device 1 comprises a continuous-time analog-to-digital converter 10, or CT-ADC 10, not visible on figure 1 but visible on figure 2, and an integrated circuit 5.

When the device 1 is in operation, the continuous-time analog-to-digital converter 10 converts an analog signal $S_{in}$ into a request signal REQ and a direction signal DIR, visible on figure 2. In other words, the CT-ADC 10 receives the analog signal $S_{in}$, which is preferentially an analog signal with a frequency equal to or below 1MHz, and outputs the request signal REQ and the direction signal DIR. The analog signal $S_{in}$ is for example an audio signal, in particular a voice signal, and the device 1 is used for voice signal processing.

The CT-ADC 10 is characterized by a given resolution, which determines a number of a plurality of predetermined levels of the CT-ADC 10. The CT-ADC 10 samples the analog signal $S_{in}$ only if the analog signal $S_{in}$ crosses one of the plurality of predetermined levels. The predetermined levels are predetermined quantization amplitude levels of the analog signal $S_{in}$ and depend on the resolution of the CT-ADC 10. The samples generated by the CT-ADC 10 form a request signal REQ and a direction signal DIR, associated to the request signal REQ. The request signal REQ comprises at least one pulse and the direction signal DIR comprises at least one state. In general, the request signal REQ comprises a plurality of pulses and the direction signal DIR comprises a plurality of states, each state being associated to a corresponding pulse. Each pulse of the request signal REQ corresponds to the analog signal $S_{in}$ crossing one of the predetermined level and comprises a rising edge. Each state on the direction signal DIR is either high state, corresponding to an increase in the amplitude level of the analog signal $S_{in}$, or low, corresponding to a decrease in the amplitude level of the analog signal $S_{in}$. In other terms, the CT-ADC 10 encodes asynchronously the analog signal $S_{in}$, the predetermined levels being the corresponding quantization levels.

As the CT-ADC 10 samples the analog signal $S_{in}$ only based on the amplitude of the analog signal $S_{in}$ and not based on a sampling frequency, the time between two successive rising edges in the request signal REQ is unknown and may vary.

The integrated circuit 5 is connected to the CT-ADC 10 and comprises at least one digital processing module 14, visible on figure 2. Each digital processing module 14 comprises a filtering unit 11, a pulse combiner 16 and an energy estimator 17. The filtering unit 11 is configured to perform continuous-time finite impulse response filtering operations. The filtering unit 11 comprises a delaying module 12 and a calculating module 15.

In figures 2 to 4, only one digital processing module 14 is represented and does not share the delaying module 12 with other digital processing modules 14. As an alternative, the device 1 comprises eight digital processing modules 14 for voice processing applications, but could comprise more or less, for example between one to sixteen digital processing modules 14, and up to thirty-two or sixty-four digital processing modules 14. The digital processing modules 14 may share components between themselves, such as the delaying module 12, as visible on figure 1, where one delaying module 12 is shared by all digital processing modules 14. Alternatively, all digital processing modules 14 may be fully separated and do not share any components. Advantageously, the integrated circuit 5 comprises at least one fully depleted silicon on insulator transistor, in particular at least one 28nm fully depleted silicon on insulator transistor, which is used to implement on-chip the digital processing modules 14.

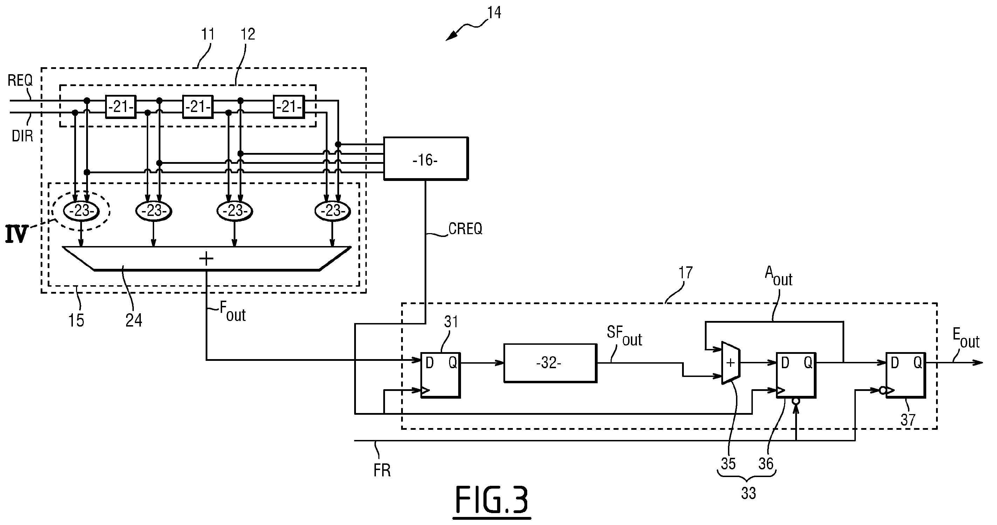

The delaying module 12 is connected to the CT-ADC 10. When the device 1 is in operation, the delaying module 12 is configured to receive the request and direction signals REQ and DIR output by the CT-ADC 10. The delaying module 12 comprises at least one delay block 21, and advantageously comprises a plurality of successive delay blocks 21, as shown in figure 3.

Figure 3 shows three delay blocks 21 as an example, but the delaying module 12 alternatively comprises more or less delay blocks 21, for example between one and twenty delay blocks 21, for example sixteen delay blocks 21. Each delay block 21 delays signals it receives by a given delay time. This given delay time is advantageously configurable by external means. In the example of the figures, each delay block 21 is identical, and delays the signals it receives by the same delay time. The delay time is for example set between 10 and 100μs, for example is equal to 62.5μs when performing voice signal processing.

The delay blocks 21 are arranged sequentially, so that when the device 1 is in operation, an output signal of a first delay block 21 is received by a second delay block 21. Therefore, a signal passing through the delay blocks 21 is delayed by an integer multiple of the delay time, the integer multiple being equal to the number of delay blocks 21 the signal went through.

In the examples of figures 2 to 4, the request signal REQ and the direction signal DIR are received by the delay blocks 21. A first delay block 21 thus outputs a delayed request signal and a delayed direction signal, both delayed request and direction signals being delayed by the delay time. Thus, the delayed direction signal maintains its association with the delayed request signal. The delayed request and direction signals are then received by a following delay block 21, which outputs further delayed request and direction signals. The delaying module 12 outputs the request signal REQ and the direction signal DIR and the delayed request and direction signals delayed by the three delay blocks 21.

In a variant, not represented, the delay blocks may not have the same behaviour and delay the signal by a different delay time. In this case, a signal passing through the delay blocks is delayed by the sum of all the delay times of the delay blocks it passes through.

The calculating module 15 is connected to the delaying module 12. The calculating module 15 comprises at least one multiply-accumulate block 23 and a summation unit 24. Advantageously, the calculating module 15 comprises one more multiply-accumulate blocks 23 than there are delay blocks 21 in the delaying module 12. In the example shown on figure 3, the calculating module 15 comprises four multiply-accumulate blocks 23, and the delaying module 12 comprises three delay blocks 21.

A first multiply-accumulate block 23 is connected to the delaying module 12 and receives the request and direction signals REQ and DIR, and the other multiply-accumulate blocks 23 are each connected to one of the delay blocks 21 of the delaying module 12 and receive the delayed direction and request signals from each delay block 21.

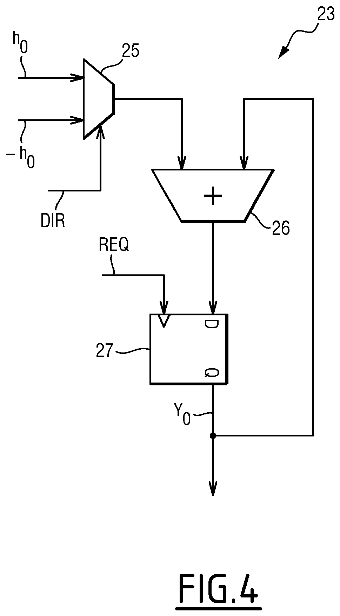

A detailed schematic of a structure of the first multiply-accumulate block 23 is shown on figure 4.

In the example of the figures, each multiply-accumulate block 23 has an identical structure. Each multiply-accumulate block 23 comprises a logic multiplexer 25, a summation unit 26 and a D flip-flop 27. The summation unit 26 is connected on one input to an output of the logic multiplexer 25 and on another input to an output port of the D flip-flop 27. The summation unit 26 is connected on an output to a data input port of the D flip-flop 27.

Each multiply-accumulate block 23 is associated with a coefficient $h_i$, with i an integer ranging from 0 to k-1, k being the number of multiply-accumulate blocks 23. In other terms, k is also called a length of the filtering unit 11, and k-1 the order of the filter 11.

In the example shown in figure 3, k is equal to four, but may be more or less, generally between one and thirty-two. The coefficients $h_i$ are advantageously stored in a memory, not represented, and are received respectively by the logic multiplexers 25 of each multiply-accumulate block 23. The coefficients $h_i$ are advantageously configured, for example by a user of the device 1, according to the analog signal $S_{in}$, and desired characteristics of the filtering unit 11.

For example, in the case of voice signal processing, the coefficients $h_i$ are chosen so that one of the filtering units 11 is a band pass filter with a bandwidth comprised between 573.8Hz and 1079.5Hz with an out-of-band attenuation of 5dB.

The following description refers to the first multiply-accumulate block 23, connected to the CT-ADC 10 and configured to receive the request and direction signals REQ and DIR. It is applicable to all the other multiply-accumulate blocks 23 by changing the request and direction signals REQ and DIR into the delayed request and direction signals.

When the device 1 is in operation, the logic multiplexer 25 of the first multiply-accumulate block 23 receives the value of the coefficient $h_0$ it is associated with, and the direction signal DIR. The logic multiplexer 25 then outputs either the value of the coefficient $h_0$, or its opposite $-h_0$, based on a value of the direction signal DIR. For example, if the direction signal DIR is in high state, the logic multiplexer 25 outputs the value $h_0$. If the direction signal DIR is in low state, the logic multiplexer 25 outputs the value $-h_0$. As an alternative, the logic multiplexer 25 outputs the value $h_0$ if the direction signal DIR is in low state and the logic multiplexer 25 outputs the value $-h_0$ if the direction signal DIR is in high state. This value is then added by the summation unit 26 with an output value of the D flip-flop 27 to obtain a summation value, which is received by the D flip-flop 27. The D flip-flop 27 also receives the request signal REQ, and when a rising edge in the request signal REQ occurs, the D flip-flop 27 is triggered and outputs an output value $Y_0$ of the first multiply-accumulate block 23, which is equal to the summation value.

In other words, the output value $Y_0$ of the first multiply-accumulate block 23 is determined by the following equation:

$$Y_0(t_n) = \begin{cases} Y_0(t_{n-1}) + h_0 \text{ , } if\ REQ = 1\ and\ DIR = 1 \\ Y_0(t_{n-1}) - h_0 \text{ , } if\ REQ = 1\ and\ DIR = 0 \end{cases}$$

$t_{n-1}$, $t_n$ are successive times corresponding to a rising edge in the request signal REQ. As the rising edges are not uniform, the successive times $t_{n-1}$, and $t_n$ are not separated by a regular interval.

Initially, the output value $Y_0$ is equal to zero. The output value $Y_0$ is the quantization value associated to the request signal REQ, multiplied by coefficient $h_0$.

A filtered output signal $F_{out}$ from the calculating module 15 is then obtained by summing the output values of all the multiply-accumulate blocks 23, which is performed by the summation unit 24. The filtered output signal $F_{out}$ is therefore a

result of the finite impulse response filtering operation performed by the filter 11 on the request signal REQ and the direction signal DIR. The filtered output signal $F_{out}$ varies when the output value of each multiply-accumulate block 23 varies.

The pulse combiner 16 is connected to the CT-ADC 10 and to all the REQ outputs of all the delay blocks 21, as presented in figure 3. When the device 1 is in operation, the pulse combiner 16 receives the request signal REQ and the delayed request signals that are output by the delay blocks 21. The pulse combiner 16 then outputs a combined request signal CREQ. The combined request signal CREQ is advantageously a concatenation of the request signal REQ and the delayed request signals received by the pulse combiner 16. The concatenation is advantageously performed by a logical "OR" operation. Optionally, the pulse combiner 16 further comprises a synchronizing block, not represented, to take into account propagation delays caused by the multiply-accumulate blocks 23 and the summation unit 24, for example by adding a programmable delay, so that the combined request signal CREQ and the filtered output signal $F_{out}$ are synchronized. The combined request signal CREQ advantageously forms a non-uniformly distributed time base suitable to track variations of the filtered output signal $F_{out}$.

The energy estimator 17 is connected to the filtering unit 11 and to the pulse combiner 16. The energy estimator 17 advantageously comprises a D flip-flop 31, a combinatory squarer 32 and an accumulator 33, visible on figure 3.

The D flip-flop 31 is connected to the combinatory squarer 32.

When the device 1 is in operation, the D flip-flop 31 receives the filtered output signal $F_{out}$ and the combined pulse signal CREQ. For each rising edge of the combined pulse signal CREQ, the D flip-flop 31 is triggered and outputs a corresponding filtered output signal value, which is then received by the combinatory squarer 32. The combinatory squarer 32 calculates and outputs a squared filtered output signal $SF_{out}$, which is the square value of the filtered output signal $F_{out}$.

In a variant, the squared filtered output signal $SF_{out}$ is an approximation of the square value of the filtered output signal $F_{out}$.

The accumulator 33 is connected to the combinatory squarer 32. The accumulator 33 comprises a summation unit 35 and a resettable D flip-flop 36. The summation unit 35 is connected in input to the combinatory squarer 32 and to the Q output port of the resettable D flip-flop 36. The resettable D flip-flop 36 is further connected to an output port of the summation unit 35 and to the pulse combiner 16. A D flip-flop 37 is connected to the resettable D flip-flop 36.

When the device 1 is in operation, the squared filtered output signal $SF_{out}$ is received by the summation unit 35. The summation unit 35 adds the squared filtered output signal $SF_{out}$ to a stored energy value $A_{out}$ in the resettable D flip-flop 36 to obtain an updated energy value. The stored energy value $A_{out}$ is then modified to the updated energy value at each rising edge in the combined request signal CREQ. More precisely, the resettable flip-flop 36 outputs the updated energy value at each rising edge in the combined request signal CREQ, so that the stored energy value $A_{out}$ is modified to the updated energy value.

The combined request signal CREQ acts as a time-base for energy calculation, as it is used to determine when to modify the stored energy value $A_{out}$.

When the device 1 is in operation, the resettable D flip-flop 36 further receives a frame signal FR. The frame signal FR comprises at least one alternating low and high state. In general, the frame signal FR comprises multiple low states alternating with multiple high states. The low and high states are advantageously regular, such that the frame signal FR is periodic. In variant, the frame signal FR is not periodic.

When the frame signal FR goes from a high state to a low state, also called a falling edge, the resettable D flip-flop 36 is reset and the D flip-flop 37 is activated. The D flip-flop 37 outputs an energy value $E_{out}$ equal to the stored energy value $A_{out}$, and the stored energy value $A_{out}$ is set to zero. The stored energy value $A_{out}$ stays equal to zero until the frame signal FR goes from a low state to a high state, also called rising edge, at which time the stored energy value $A_{out}$ is modified again at each rising edge in the combined request signal CREQ, as previously described.

As an alternative, the resettable D flip-flop 36 is reset and the D flip-flop 37 is activated when a rising edge occurs in the frame signal FR, and the stored energy value $A_{out}$ stays equal to zero until a falling edge occurs in the frame signal FR.

The energy value $E_{out}$ corresponds to an approximation of an energy of the analog signal $S_{in}$ in a frequency range corresponding to the bandwidth of the filtering unit 11, calculated over a high state of the frame signal FR. As the rising edges comprised in the combined request signal CREQ are not distributed uniformly and the time between two successive rising edges in the combined request signal CREQ may vary, the energy value $E_{out}$ is calculated without ponderation of the time between successive rising edges in the combined request signal CREQ. In other words, even though the time between two rising edges in the combined request signal CREQ may vary, when calculating the energy value $E_{out}$, it is considered that all the rising edges in the combined request signal CREQ are evenly distributed. Thus, the energy value $E_{out}$ is not exactly equal to the energy of the analog signal $S_{in}$. A discrepancy between the energy value $E_{out}$ and an energy value output by a similar device through discrete time digital signal processing is low, advantageously of less than 1% on average in a voice signal processing application.

The energy value $E_{out}$ is advantageously used to display a spectrogram for a frequency interval corresponding to the bandwidth of the filtering unit 11, by collecting energy values $E_{out}$ over multiple time frames.

Alternatively, for voice signal processing applications such as keyword spotting, the estimated energy values $E_{out}$

are used as features extracted from the voice signal. The energy values are advantageously stored in a dedicated memory unit, where additional processing, such as leading one detection and truncation of the energy values $E_{out}$ can be performed. The truncated energy values are advantageously used as input to a neural network trained to detect predetermined keywords.

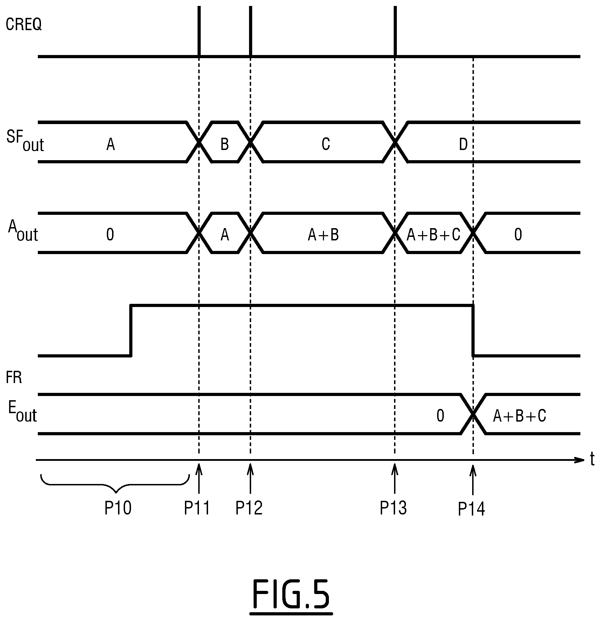

Figure 5 represents an example of an evolution of signals received and output by the accumulator 33 when the device 1 is in operation.

During phase P10, before a rising edge occurs in the combined request signal CREQ, the squared filtered output signal $SF_{out}$ is constant, equal to value A, the stored energy value $A_{out}$ is equal to zero, and the energy value $E_{out}$ is equal to zero. A rising edge occurs in the frame signal FR, with no impact on the values previously mentioned.

At each phase P11, P12 and P13, which each correspond to a rising edge at the combined request signal CREQ, the squared filtered output signal $SF_{out}$ changes, as a rising edge in the combined request signal CREQ is synchronized with a change in the filtered output signal $F_{out}$. The stored energy $A_{out}$ changes as well, and becomes the updated energy value, which is a sum of the stored energy value $A_{out}$ and the value of the squared filtered output signal $SF_{out}$ before each rising edge occured. In the example of figure 5, after phase P11, the squared filtered output signal $SF_{out}$ becomes equal to value B and the stored energy value $A_{out}$ becomes equal to value A. Similarly, after phases P12 and P13, but before phase P14, the squared filtered output signal $SF_{out}$ successively becomes equal to values C and D and $A_{out}$ successively becomes equal to value A+B and A+B+C. The energy value $E_{out}$ stays constant, equal to zero, or to the previous energy value $E_{out}$.

At phase P14, a falling edge occurs on the frame signal FR. This causes the energy value $E_{out}$ to become equal to the stored energy value $A_{out}$, and the stored energy value $A_{out}$ to be reset to zero. Thus, a high state in the frame signal FR corresponds to a time duration over which the energy value $E_{out}$ is calculated. The value of the squared filtered signal $SF_{out}$ is not modified.

The combined request signal CREQ is used as an unevenly distributed time base in order to synchronise the operation of the filtering unit 11 with the combinatory squarer 32 and the accumulator 33. More precisely, the combined request signal CREQ is used to follow every variation of the filtered output signal $F_{out}$, so that the energy value $E_{out}$ is a function of all the variations of the filtered output signal $F_{out}$.

The operation of the device 1 requires little power due to the device 1 performing continuous-time processing. Indeed, in this case the device 1 consumes power only if the analog signal $S_{in}$ reaches predetermined levels. In case of silence, or low background noise, the CT-ADC 10 does not sample the analog signal $S_{in}$, resulting in reduced power consumption. A power consumption of the microchip 5 of the device 1 is for example in a voice signal processing application, lower than $1\mu W$, preferentially lower than 500nW. In particular, a power consumption of the energy estimator 17 is lower than 5nW, preferentially lower than 2nW when detecting keywords in audio signals. The values may vary, depending on the application and the type of signal.

In a variant not represented, the pulse combiner is not connected to all the delay blocks. In this case, the pulse combiner does not take into account the delayed request signals output by the delay blocks which are not connected to the pulse combiner. This results in the variations in the filtered output caused by a delay block not connected to the pulse combiner being ignored when calculating the energy values. As an alternative, some delay blocks are deactivated, and do not transmit delayed request signals to the pulse combiner. Both cases allow to obtain an effect similar to modifying the order of the filtering unit without changing an architecture of the filtering unit. Advantageously, the user determines if the pulse combiner is connected to all the delay blocks or not, and if not, to which delay blocks the pulse combiner is connected, or which delay blocks are deactivated.

In a variant not represented, each digital processing module comprises more than one energy estimator, for example three energy estimators. When the device is in operation, the energy estimators of the same digital processing module advantageously receive a different frame signal. The frame signals advantageously overlap. The energy value can thus be calculated over different overlapping time durations.

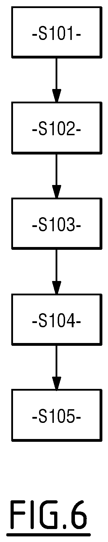

A method for calculating the energy value $E_{out}$ is now described in relation to figure 6.

A step S101 consists in converting the analog signal $S_{in}$. The analog signal $S_{in}$ is converted into the request signal REQ and the direction signal DIR associated to the request signal REQ. The request signal REQ comprises at least one pulse comprising a rising edge, each pulse being representative of the analog signal $S_{in}$ crossing one of the plurality of predetermined levels, as described previously. The direction signal DIR is representative of the direction of the level crossing. Step S101 is advantageously performed by the CT-ADC 10.

Filtering the request signal REQ and direction signal DIR is then performed. More precisely, the filtering is a finite impulse response filtering operation and results in outputting the filtered output signal $F_{out}$. Filtering consists in two steps, a step S102 and a step S103.

Step S102 consists in delaying the request signal REQ and the associated direction signal DIR. Step S102 results in the output of at least one delayed request signal, and the at least one delayed direction signal associated to the at least one delayed request signal. The delayed request signal is delayed from the request signal REQ by the delay time, and the delayed direction signal is delayed from the direction signal DIR by the same delay time. Advantageously, and as shown in

**EP 4 482 036 B1**

the figures, a plurality of delayed request signals, and a plurality of delayed direction signals associated to the delayed request signals are output, as well as the request signal DIR and direction signal REQ. Advantageously, step S102 is performed by the delaying module 12.

Step S103 consists in calculating the filtered output signal $F_{out}$ from the request signal REQ, the direction signal DIR, the delayed request signals and the delayed direction signals.

A step S104 of combining the request signal REQ and the at least one delayed request signal is then performed. The combination of the request signal REQ and the at least one delayed request signal results in the combined request signal CREQ. Step S104 is advantageously performed by the pulse combiner 16.

A step S105 of computing the stored energy value $A_{out}$ associated with each rising edge of the combined request signal CREQ using the filtered output signal $F_{out}$ is performed. The squared filtered output signal $SF_{out}$ is first output and the value of the stored energy value $A_{out}$ is computed from the squared filtered output signal $SF_{out}$. Step S105 is advantageously performed by the accumulator 33.

A step of outputting the energy value $E_{out}$ is performed when a falling edge occurs on the frame signal FR.

The device 1 performs low power energy calculation of the analog signal $S_{in}$, through continuous-time digital processing. The pulse combiner 16 of the device 1 allows to create a time base usable to output the energy value $E_{out}$, therefore making continuous-time digital processing compatible with energy calculations.

Advantageously, as previously mentioned, even though the rising edges comprised in the combined request signal CREQ are not distributed uniformly, a difference between the energy value $E_{out}$ output by the device 1 and an energy value output by a similar device using discrete time digital processing is low, with for example the discrepancy being of less than 1% on average in voice signal processing applications. This allows the enegy value $E_{out}$ to be exploited in a similar way as the energy value which is obtained through discrete time digital processing. In an application using voice signal processing for keyword recognition by a convolutional neural network, using the device 1 resulted in 90.08% accuracy, and using a similar device performing discrete-time signal processing resulted in 90.21% accuracy. The number of digital processing modules 14, the order of the filtering unit 11 and the number of energy estimators 17 are advantageously chosen depending on an application desired by the user. For example, choosing eight digital processing modules 14, with filtering units 11 with an order of sixteen allows the user to process an audio analog signal $S_{in}$ corresponding to a voice signal.

**Claims**

1. Device (1), for continuous-time energy calculation of an analog signal ($S_{in}$), comprising:

    - a continuous-time analog-to-digital converter (10), configured to convert the analog signal ($S_{in}$) into a request signal (REQ), the request signal (REQ) comprising at least one pulse, each pulse being representative of the analog signal ($S_{in}$) crossing one of a plurality of predetermined levels, and a direction signal (DIR), associated to the request signal (REQ), the direction signal (DIR) being representative of a direction of the level crossing;
    - at least one filtering unit (11), configured to perform a continuous-time finite impulse response filtering operation, the at least one filtering unit (11) being configured to receive the request signal (REQ), the direction signal (DIR), and to output a filtered output signal ($F_{out}$), the at least one filtering unit (11) comprising:

        o a delaying module (12), configured to receive the request signal (REQ) and the direction signal (DIR), and to output at least one delayed request signal, delayed from the request signal (REQ) by a delay time, and at least one delayed direction signal, delayed from the direction signal (DIR) by the delay time, the at least one delayed request signal being associated with one of the at least one delayed direction signal; and
        o a calculating module (15), connected to the delaying module (12) the calculating module (15) being configured to receive the request signal (REQ), the direction signal (DIR), the at least one delayed request signal and the at least one delayed direction signal and to calculate the filtered output signal ($F_{out}$);

    wherein the device (1) further comprises:

        - at least one pulse combiner (16), connected to the delaying module (12), the at least one pulse combiner (16) being configured to receive the request signal (REQ) and the at least one delayed request signal and to output a combined request signal (CREQ); and
        - at least one energy estimator (17), connected to the filtering unit (11) and to the pulse combiner (16), the at least one energy estimator (17) being configured to receive the filtered output signal ($F_{out}$) and the combined request signal (CREQ) and configured to compute a stored energy value ($A_{out}$) associated with each pulse of the combined request signal (CREQ).

8

**2.** Device (1) according to claim 1, wherein the combined request signal (CREQ) is a result of a concatenation of the request signal (REQ) and the at least one delayed request signal.

**3.** Device (1) according to any of the preceding claims, wherein the delaying module (12) comprises a plurality of successive delay blocks (21), each delay block (21) applying said delay time, a delayed request signal and a delayed direction signal being obtained as an output of each delay block (21).

**4.** Device (1) according to claim 3, wherein the at least one calculating module (15) comprises a plurality of multiply-accumulate blocks (23), each multiply-accumulate block (23) receiving one of the plurality of delayed request signals and the delayed direction signal associated to the delayed request signal, or the request signal (REQ) and direction signal (DIR).

**5.** Device (1) according to claim 4, wherein each multiply-accumulate block (23) **is** associated with a coefficient ($h_i$).

**6.** Device (1) according to any of claims 4 or 5, wherein the at least one pulse combiner (16) is configured to receive all or only some of the plurality of delayed request and associated direction signals.

**7.** Device (1) according to claim 1, wherein the at least one energy estimator (17) comprises:

- a combinatory squarer (32) configured to output a squared filtered output signal ($SF_{out}$) at each rising edge of the combined request signal (CREQ);
- an accumulator (33), configured to add the squared filtered output signal ($SF_{out}$) to a stored energy value ($A_{out}$) to obtain an updated energy value and to set a value of the stored energy value ($A_{out}$) to the updated energy value at each rising edge of the combined request signal (CREQ), and wherein the accumulator (33) is further configured to receive a frame signal (FR), comprising alternating high states and low states, and when the frame signal (FR) goes from a high state to a low state, to output the stored energy value ($A_{out}$) and then set the stored energy value ($A_{out}$) to zero.

**8.** Device (1) according to claim 7, comprising a plurality of energy estimators (17), each energy estimator (17) being configured to receive a different frame signal (FR).

**9.** Device (1) according to any of the preceding claims, wherein the delaying module (12) and/or the at least one calculating module (15) and/or the at least one pulse combiner (16) and/or the at least one energy estimator (17) is implemented on an integrated circuit (5) comprising at least one fully depleted silicon on insulator transistor.

**10.** Method for continuous-time energy calculation of an analog signal ($S_{in}$), the method being implemented by a device (1) according of any of the preceding claims, the method comprising:

- converting (S101) the analog signal ($S_{in}$) into the request signal (REQ), the request signal (REQ) comprising at least one pulse, each pulse being representative of the analog signal ($S_{in}$) crossing one of the plurality of predetermined levels, and into the direction signal (DIR), associated to the request signal (REQ), the direction signal (DIR) being representative of the direction of the level crossing;
- filtering the request signal (REQ) and the direction signal (DIR) by a finite impulse response filtering operation
- the filtering comprising:

o delaying (S102) the request signal (REQ) and the associated direction signal (DIR) to output the at least one delayed request signal, delayed from the request signal by the delay time, and the delayed direction signal associated to the at least one delayed request signal, delayed from the direction signal by the delay time;
o calculating (S103) from the request signal (REQ), the direction signal (DIR), the at least one delayed request signal and the at least one delayed direction signal the filtered output signal ($F_{out}$);

- combining (S104) the request signal (REQ) and the at least one delayed request signal into the combined request signal (CREQ) acting as a non-uniform time base; and
- computing (S105) the stored energy value ($A_{out}$) associated with each pulse of the combined request signal (CREQ) from the filtered output signal ($F_{out}$).

**Patentansprüche**

1. Vorrichtung (1) zur zeitkontinuierlichen Energieberechnung eines analogen Signals ($S_{in}$), umfassend:

   - einen zeitkontinuierlichen Analog-Digital-Wandler (10), der so konfiguriert ist, dass er das analoge Signal ($S_{in}$) in ein Anforderungssignal (REQ), wobei das Anforderungssignal (REQ) mindestens einen Impuls umfasst, wobei jeder Impuls das analoge Signal ($S_{in}$) darstellt, das eines von einer Vielzahl von vorbestimmten Niveaus überschreitet, und ein Richtungssignal (DIR) umwandelt, das dem Anforderungssignal (REQ) zugeordnet ist, wobei das Richtungssignal (DIR) eine Richtung des Niveauüberschreitens darstellt;
   - mindestens eine Filtereinheit (11), die so konfiguriert ist, dass sie eine zeitkontinuierliche Filterungsoperation mit begrenzter Impulsantwort durchführt, wobei die mindestens eine Filtereinheit (11) so konfiguriert ist, dass sie das Anforderungssignal (REQ) und das Richtungssignal (DIR) empfängt und ein gefiltertes Ausgangssignal ($F_{out}$) ausgibt, wobei die mindestens eine Filtereinheit (11) Folgendes umfasst:

      o ein Verzögerungsmodul (12), das so konfiguriert ist, dass es das Anforderungssignal (REQ) und das Richtungssignal (DIR) empfängt und mindestens ein verzögertes Anforderungssignal, verzögert vom Anforderungssignal (REQ) um eine Verzögerungszeit, und mindestens ein verzögertes Richtungssignal, verzögert vom Richtungssignal (DIR) um die Verzögerungszeit, ausgibt, wobei das mindestens eine verzögerte Anforderungssignal einem der mindestens einen verzögerten Richtungssignale zugeordnet ist; und
      o ein Rechenmodul (15), das mit dem Verzögerungsmodul (12) verbunden ist, wobei das Rechenmodul (15) so konfiguriert ist, dass es das Anforderungssignal (REQ), das Richtungssignal (DIR), das mindestens eine verzögerte Anforderungssignal und das mindestens eine verzögerte Richtungssignal empfängt und das gefilterte Ausgangssignal ($F_{out}$) berechnet;
      wobei die Vorrichtung (1) ferner Folgendes umfasst:

      - mindestens einen Impulskombinator (16), der mit dem Verzögerungsmodul (12) verbunden ist, wobei der mindestens eine Impulskombinator (16) so konfiguriert ist, dass er das Anforderungssignal (REQ) und das mindestens eine verzögerte Anforderungssignal empfängt und ein kombiniertes Anforderungssignal (CREQ) ausgibt; und
      - mindestens ein Energie-Schätzer (17), der mit der Filtereinheit (11) und dem Impulskombinator (16) verbunden ist, wobei der mindestens eine Energie-Schätzer (17) so konfiguriert ist, dass er das gefilterte Ausgangssignal ($F_{out}$) und das kombinierte Anforderungssignal (CREQ) empfängt, und so konfiguriert ist, dass er einen gespeicherten Energiewert ($A_{out}$) berechnet, der jedem Impuls des kombinierten Anforderungssignals (CREQ) zugeordnet ist.

2. Vorrichtung (1) nach Anspruch 1, wobei das kombinierte Anforderungssignal (CREQ) das Ergebnis einer Verkettung des Anforderungssignals (REQ) und des mindestens einen verzögerten Anforderungssignals ist.

3. Vorrichtung (1) nach einem der vorhergehenden Ansprüche, wobei das Verzögerungsmodul (12) eine Vielzahl von aufeinanderfolgenden Verzögerungsblöcken (21) umfasst, wobei jeder Verzögerungsblock (21) die Verzögerungszeit anwendet, wobei ein verzögertes Anforderungssignal und ein verzögertes Richtungssignal als Ausgang jedes Verzögerungsblocks (21) erhalten werden.

4. Vorrichtung (1) nach Anspruch 3, wobei das mindestens eine Rechenmodul (15) eine Vielzahl von Multiplikations-Akkumulations-Blöcken (23) umfasst, wobei jeder Multiplikations-Akkumulations-Block (23) eines der Vielzahl von verzögerten Anforderungssignalen und das dem verzögerten Anforderungssignal zugeordneten verzögerten Richtungssignal oder das Anforderungssignal (REQ) und das Richtungssignal (DIR) empfängt.

5. Vorrichtung (1) nach Anspruch 4, wobei jeder Multiplikations-Akkumulations-Block (23) einem Koeffizienten ($h_i$) zugeordnet ist.

6. Vorrichtung (1) nach einem der Ansprüche 4 oder 5, wobei der mindestens eine Impulskombinator (16) so konfiguriert ist, dass er alle oder nur einen Teil der Vielzahl von verzögerten Anforderungs- und zugehörigen Richtungssignalen empfängt.

7. Vorrichtung (1) nach Anspruch 1, wobei der mindestens eine Energie-Schätzer (17) Folgendes umfasst:

   - einen kombinatorischen Quadrierer (32), der so konfiguriert ist, dass er bei jeder steigenden Flanke des kombinierten Anforderungssignals (CREQ) ein quadriertes gefiltertes Ausgangssignal (SF$_{out}$) ausgibt;
- einen Akkumulator (33), der so konfiguriert ist, dass er das quadrierte gefilterte Ausgangssignal (SF$_{out}$) zu einem gespeicherten Energiewert (A$_{out}$) addiert, um einen aktualisierten Energiewert zu erhalten, und dass er den Wert des gespeicherten Energiewerts (A$_{out}$) bei jeder steigenden Flanke des kombinierten Anforderungssignals (CREQ) auf den aktualisierten Energiewert setzt, wobei der Akkumulator (33) ferner so konfiguriert ist, dass er ein Rahmensignal (FR) empfängt, das abwechselnd hohe Zustände und niedrige Zustände umfasst, und, wenn das Rahmensignal (FR) von einem hohen Zustand in einen niedrigen Zustand übergeht, den gespeicherten Energiewert (A$_{out}$) ausgibt und dann den gespeicherten Energiewert (A$_{out}$) auf Null setzt.

8. Vorrichtung (1) nach Anspruch 7, umfassend eine Vielzahl von Energie-Schätzern (17), wobei jeder Energie-Schätzer (17) so konfiguriert ist, dass er ein anderes Rahmensignal (FR) empfängt.

9. Vorrichtung (1) nach einem der vorhergehenden Ansprüche, wobei das Verzögerungsmodul (12) und/oder das mindestens eine Rechenmodul (15) und/oder der mindestens eine Impulskombinator (16) und/oder der mindestens eine Energie-Schätzer (17) auf einer integrierten Schaltung (5) implementiert ist, die mindestens einen vollständig verarmten Silizium-auf-Isolator-Transistor umfasst.

10. Verfahren zur zeitkontinuierlichen Energieberechnung eines analogen Signals (S$_{in}$), wobei das Verfahren von einer Vorrichtung (1) nach einem der vorhergehenden Ansprüche implementiert wird, wobei das Verfahren Folgendes umfasst:

- Umwandeln (S101) des analogen Signals (S$_{in}$) in das Anforderungssignal (REQ), wobei das Anforderungssignal (REQ) mindestens einen Impuls umfasst, wobei jeder Impuls das analoge Signal (S$_{in}$) darstellt, das eines von der Vielzahl von vorbestimmten Niveaus überschreitet, und in das Richtungssignal (DIR), das mit dem Anforderungssignal (REQ) verbunden ist, wobei das Richtungssignal (DIR) die Richtung des Niveauüberschreitens darstellt;
- Filtern des Anforderungssignals (REQ) und des Richtungssignals (DIR) durch eine Filterungsoperation mit begrenzter Impulsantwort,
- wobei das Filtern Folgendes umfasst:

o Verzögern (S102) des Anforderungssignals (REQ) und des zugehörigen Richtungssignals (DIR), um das mindestens eine verzögerte Anforderungssignal, verzögert vom Anforderungssignal um die Verzögerungszeit, und das verzögerte Richtungssignal, das dem mindestens einen verzögerten Anforderungssignal zugeordnet ist, verzögert vom Richtungssignal um die Verzögerungszeit, auszugeben;
o Berechnen (S103) des gefilterten Ausgangssignals (F$_{out}$) aus dem Anforderungssignal (REQ), dem Richtungssignal (DIR), dem mindestens einen verzögerten Anforderungssignal und dem mindestens einen verzögerten Richtungssignal;

- Kombinieren (S104) des Anforderungssignals (REQ) und des mindestens einen verzögerten Anforderungssignals in das kombinierte Anforderungssignal (CREQ), das als nicht einheitliche Zeitbasis wirkt; und
- Berechnen (S105) des gespeicherten Energiewerts (A$_{out}$), der jedem Impuls des kombinierten Anforderungssignals (CREQ) zugeordnet ist, aus dem gefilterten Ausgangssignal (F$_{out}$).

**Revendications**

1. Dispositif (1), pour le calcul d'énergie continu dans le temps d'un signal analogique (S$_{in}$), comprenant :

- un convertisseur analogique-numérique continu dans le temps (10), configuré pour convertir le signal analogique (S$_{in}$) en signal de demande (REQ), le signal de demande (REQ) comprenant au moins une impulsion, chaque impulsion étant représentative du signal analogique (S$_{in}$) franchissant l'un d'une pluralité de niveaux prédéterminés, et en signal de direction (DIR), associé au signal de demande (REQ), le signal de direction (DIR) étant représentatif d'une direction du franchissement de niveau ;
- au moins une unité de filtrage (11), configurée pour effectuer une opération de filtrage à réponse impulsionnelle finie continue dans le temps, l'au moins une unité de filtrage (11) étant configurée pour recevoir le signal de demande (REQ), le signal de direction (DIR), et pour émettre un signal de sortie filtré (F$_{out}$), l'au moins une unité de filtrage (11) comprenant :

o un module de retard (12), configuré pour recevoir le signal de demande (REQ) et le signal de direction (DIR), et pour émettre au moins un signal de demande retardé, retardé d'un temps de retard par rapport au signal de demande (REQ), et au moins un signal de direction retardé, retardé du temps de retard par rapport au signal de direction (DIR), l'au moins un signal de demande retardé étant associé à l'un de l'au moins un signal de direction retardé ; et

o un module de calcul (15), connecté au module de retard (12), le module de calcul (15) étant configuré pour recevoir le signal de demande (REQ), le signal de direction (DIR), l'au moins un signal de demande retardé et l'au moins un signal de direction retardé et pour calculer le signal de sortie filtré ($F_{out}$) ;

dans lequel le dispositif (1) comprend en outre :

- au moins un combineur d'impulsions (16), connecté au module de retard (12), l'au moins un combineur d'impulsions (16) étant configuré pour recevoir le signal de demande (REQ) et l'au moins un signal de demande retardé et pour émettre un signal de demande combiné (CREQ) ; et
- au moins un estimateur d'énergie (17), connecté à l'unité de filtrage (11) et au combineur d'impulsions (16), l'au moins un estimateur d'énergie (17) étant configuré pour recevoir le signal de sortie filtré ($F_{out}$) et le signal de demande combiné (CREQ) et configuré pour calculer une valeur d'énergie stockée ($A_{out}$) associée à chaque impulsion du signal de demande combiné (CREQ).

2. Dispositif (1) selon la revendication 1, dans lequel le signal de demande combiné (CREQ) est un résultat d'une concaténation du signal de demande (REQ) et de l'au moins un signal de demande retardé.

3. Dispositif (1) selon l'une quelconque des revendications précédentes, dans lequel le module de retard (12) comprend une pluralité de blocs de retard (21) successifs, chaque bloc de retard (21) appliquant ledit temps de retard, un signal de demande retardé et un signal de direction retardé étant obtenus en sortie de chaque bloc de retard (21).

4. Dispositif (1) selon la revendication 3, dans lequel l'au moins un module de calcul (15) comprend une pluralité de blocs de multiplication-accumulation (23), chaque bloc de multiplication-accumulation (23) recevant l'un de la pluralité de signaux de demande retardés et le signal de direction retardé associé au signal de demande retardé, ou le signal de demande (REQ) et le signal de direction (DIR).

5. Dispositif (1) selon la revendication 4, dans lequel chaque bloc de multiplication-accumulation (23) est associé à un coefficient ($h_i$).

6. Dispositif (1) selon l'une quelconque des revendications 4 ou 5, dans lequel l'au moins un combineur d'impulsions (16) est configuré pour recevoir tout ou seulement certains de la pluralité de signaux de demande retardés et les signaux de direction associés.

7. Dispositif (1) selon la revendication 1, dans lequel l'au moins un estimateur d'énergie (17) comprend :

- un conformateur au carré combinatoire (32) configuré pour émettre un signal de sortie filtré au carré ($SF_{out}$) à chaque front montant du signal de demande combiné (CREQ) ;
- un accumulateur (33), configuré pour additionner le signal de sortie filtré au carré ($SF_{out}$) à une valeur d'énergie stockée ($A_{out}$) pour obtenir une valeur d'énergie mise à jour et pour régler une valeur de la valeur d'énergie stockée ($A_{out}$) sur la valeur d'énergie mise à jour à chaque front montant du signal de demande combiné (CREQ), et dans lequel l'accumulateur (33) est en outre configuré pour recevoir un signal de trame (FR), comprenant des états hauts et des états bas alternés, et lorsque le signal de trame (FR) passe d'un état haut à un état bas, pour émettre la valeur d'énergie stockée ($A_{out}$) puis régler la valeur d'énergie stockée ($A_{out}$) sur zéro.

8. Dispositif (1) selon la revendication 7, comprenant une pluralité d'estimateurs d'énergie (17), chaque estimateur d'énergie (17) étant configuré pour recevoir un signal de trame (FR) différent.

9. Dispositif (1) selon l'une quelconque des revendications précédentes, dans lequel le module de retard (12) et/ou l'au moins un module de calcul (15) et/ou l'au moins un combineur d'impulsions (16) et/ou l'au moins un estimateur d'énergie (17) sont mis en œuvre sur un circuit intégré (5) comprenant au moins un transistor silicium sur isolant complètement déserté.

10. Procédé pour le calcul d'énergie continu dans le temps d'un signal analogique ($S_{in}$), le procédé étant mis en œuvre par un dispositif (1) selon l'une quelconque des revendications précédentes, le procédé comprenant :

- la conversion (S101) du signal analogique ($S_{in}$) en signal de demande (REQ), le signal de demande (REQ) comprenant au moins une impulsion, chaque impulsion étant représentative du signal analogique ($S_{in}$) franchissant l'un de la pluralité de niveaux prédéterminés, et en signal de direction (DIR), associé au signal de demande (REQ), le signal de direction (DIR) étant représentatif de la direction du franchissement de niveau ;
- le filtrage du signal de demande (REQ) et du signal de direction (DIR) par une opération de filtrage à réponse impulsionnelle finie
- le filtrage comprenant :

  o le retard (S102) du signal de demande (REQ) et du signal de direction (DIR) associé pour émettre l'au moins un signal de demande retardé, retardé du temps de retard par rapport au signal de demande, et le signal de direction retardé associé à l'au moins un signal de demande retardé, retardé du temps de retard par rapport au signal de direction ;
  o le calcul (S103), à partir du signal de demande (REQ), du signal de direction (DIR), de l'au moins un signal de demande retardé et de l'au moins un signal de direction retardé, du signal de sortie filtré ($F_{out}$) ;

- la combinaison (S104) du signal de demande (REQ) et de l'au moins un signal de demande retardé en signal de demande combiné (CREQ) faisant office de base de temps non uniforme ; et
- le calcul informatisé (S105) de la valeur d'énergie stockée ($A_{out}$) associée à chaque impulsion du signal de demande combiné (CREQ) à partir du signal de sortie filtré ($F_{out}$).

## FIG.1

EP 4 482 036 B1

FIG.2

FIG.3

FIG.4

CREQ

$SF_{out}$ | A | B | C | D

$A_{out}$ | 0 | A | A+B | A+B+C | 0

FR

$E_{out}$ | 0 | A+B+C

t

P10  P11  P12  P13  P14

# FIG.5

FIG.6

**EP 4 482 036 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2021257908 A1

**Non-patent literature cited in the description**

- Event-Driven Continuous-Time Feature Extraction for Ultra Low-Power Audio Keyword Spotting. **MOURRANE SOUFIANE et al.** 2021 IEEE 3RD INTERNATIONAL CONFERENCE ON ARTIFICIAL INTELLIGENCE CIRCUITS AND SYSTEMS (AI-CAS). IEEE, 06 June 2021, 1-4

- A Flash-Based Non-Uniform Sampling ADC With Hybrid Quantization Enabling Digital Anti-Aliasing Filter. **WU TZU-FAN et al.** IEEE JOURNAL OF SOLID-STATE CIRCUITS. IEEE, 01 September 2017, vol. 52, 2335-2349